# EUROPÄISCHE PATENTSCHRIFT

(11) **EP 0 330 209 B1**
(45) Veröffentlichungstag und Bekanntmachung des Hinweises auf die Patenterteilung: **21.07.1993**
(21) Anmeldenummer: 89103211.2
(22) Anmeldetag: 23.02.1989
(51) Int. Cl.: G03F 7/075

(54) **Photoreaktive Polymere und Verfahren zur Herstellung eines Zweilagenresists**
Photoreactive polymers and process for the production of a two-layer resist
Polymères photoréactifs et procédé pour la fabrication d'une réserve à deux couches

(30) Priorität: 26.02.1988 DE 3806088
(43) Veröffentlichungstag der Anmeldung: 30.08.1989
(73) Patentinhaber: BASF Aktiengesellschaft, 67063 Ludwigshafen (DE)
(72) Erfinder: Schwalm, Reinhold, Dr., D-6706 Wachenheim (DE); Koch, Horst, Dr., D-6718 Gruenstadt (DE)

(56) Entgegenhaltungen:
- EP-A- 0 164 100
- EP-A- 0 212 372

## Beschreibung

Die Erfindung betrifft photoreaktive Polymere mit N-Ylid-Strukturen von N-Heteroaromaten, die unter dem Einfluß von aktinischem Licht photochemische Struktur- und Eigenschaftsänderungen eingehen, hohe Resistenz gegenüber Sauerstoffplasmen zeigen und zur Herstellung von Zweilagen-Photoresists für die Herstellung von Halbleiterbauelementen geeignet sind.

Photoreaktive Polymere mit Ylid-Gruppierungen von N-Heteroaromaten sind z.B. aus EP-A- 0 164 100 und EP-A- 0 212 372 bekannt. Diese photoreaktiven Polymeren gehen unter dem Einfluß von aktinischem Licht Struktur- und Eigenschaftsänderungen, wie eine Änderung der Hydrophilie ein, so daß sie sehr brauchbare Materialien für die Strukturierung von Leiterplatten und Halbleiterbauelementen darstellen.

Um Halbleiterbauelemente mit Submikronstrukturen herzustellen, insbesondere auf Substraten mit unterschiedlicher Topographie, geht man unter anderem den Weg über Mehrlagensysteme. Stand der Technik sind Dreilagensysteme, die aus einer unteren Polymerschicht bestehen, die dazu dient, die Oberfläche des Substrates zu planarisieren, die nicht fotoempfindlich sein muß, sich jedoch bei spezieller Plasmabehandlung, z.B. im Sauerstoffplasma, vollständig abtragen lassen sollte.

Dann wird eine Zwischenschicht aufgebracht, die so gewählt wird, daß sie bei spezieller Plasmabehandlung, z.B. im Sauerstoffplasma, wesentlich langsamer geätzt wird als die darunterliegende Planarisierungsschicht. Als oberste Schicht wird ein lichtempfindliches Material, z.B. ein kommerziell erhältlicher Diazochinon-Novolak-Fotoresist, aufgebracht, welches bildmäßig belichtet und entwickelt werden kann. Der Dreilagenresist wird dann strukturiert, indem die oberste fotoempfindliche Schicht gemäß den bekannten lithographischen Verfahren belichtet und entwickelt wird, so daß Reliefstrukturen entstehen. Das erzeugte Muster wird dann mit Hilfe eines geeigneten Plasmas, z.B. fluorkohlenwasserstoffhaltigen Plasmen, in die Zwischenschicht übertragen. Das so erzeugte Muster in der Zwischenschicht dient dann als Maske für die Strukturübertragung in die Planarisierungsschicht, beispielsweise mit Hilfe eines Sauerstoffplasmas. Die Vorteile der Dreilagentechnik liegen darin, daß man eine relativ dicke Planarisierungsschicht anwenden kann, ohne an Auflösung zu verlieren, weiterhin darin, daß die obere lichtempfindliche Schicht sehr dünn sein kann (0,1 µm bis 1 µm), wobei die Auflösung mit geringerer Schichtdicke besser wird. Nachteilig ist jedoch die große Zahl der benötigten Prozeßschritte für den Aufbau und die Strukturierung der Dreilagenresiste.

Um die Anzahl der Prozeßschritte zu reduzieren, wurde eine Reihe von Materialien vorgeschlagen, die die Eigenschaften der beiden oberen Lagen kombinieren, d.h. sowohl Lichtempfindlichkeit als auch Plasmaresistenz in einer Schicht vereinigen. Solche Materialien enthalten beispielsweise Organosilizium-, Organozinn- oder Organotitangruppen im Molekül.

Einen Überblick über siliziumhaltige Resiste für Zweilagensysteme gibt z.B. H. Gokan in SPIE-International Society for Optical Engineering Vol. 539, Advances in Resist Technology and Processing II, Seiten 62 - 68 (1985).

Die bekannten Resiste für die Zweilagentechnik zeigen alle Resistenz im Sauerstoffplasma, wenn ein bestimmter Mindestgehalt an Siliziumatomen im Molekül enthalten ist, jedoch jedes System für sich spezielle Nachteile bezüglich Lichtempfindlichkeit, Verarbeitbarkeit, Entwickelbarkeit oder thermischer Stabilität. Beispielsweise sind die meisten Polymeren nur in organischen Lösungsmitteln löslich und deshalb nur schwer im Zweilagenaufbau zu verarbeiten, da ein Anlösen der unteren Planarisierungsschicht vermieden werden muß. Die bekannten Polymeren mit N-Ylidgruppierungen sind dagegen in reinem Wasser löslich und daher problemlos in der Zweilagentechnik zu verarbeiten, die bekannten Systeme werden jedoch im Sauerstoffplasma ebenso rasch abgetragen wie die Planarisierungsschichten.

Aufgabe der vorliegenden Erfindung war es, wasserlösliche, lichtempfindliche Polymere, die Resistenz im Sauerstoffplasma zeigen, zur Verfügung zu stellen.

Es wurde nun gefunden, daß diese Aufgabe durch spezielle Copolymerisate gelöst werden kann, die sowohl N-Ylidgruppierungen als auch mindestens 6 Gew.% Silizium enthalten. Diese Polymeren sind besonders geeignet für die Herstellung von Zweilagenresistsystemen mit der Charakteristik von Dreilagenresisten zur Fertigung von Halbleiterbauelementen.

Gegenstand der vorliegenden Erfindung sind photoreaktive, Ylidgruppen enthaltende Copolymerisate, die unter dem Einfluß von aktinischem Licht photochemische Struktur- und Eigenschaftsänderungen eingehen, und die dadurch gekennzeichnet sind, daß die Copolymerisate einpolymerisiert enthalten
(a) 5 bis 50 Mol% mindestens einer Verbindung der allgemeinen Formel (I) 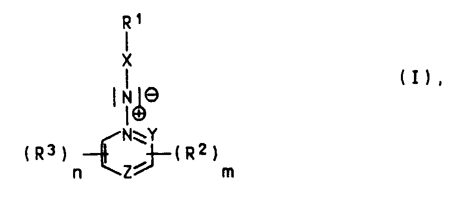 worin bedeuten
   - Y und Z:: =CR³- oder
   - Z:: =N- und Y: =CR³- oder
   - Y:: =N- und Z: =CR³-,
   - X:: 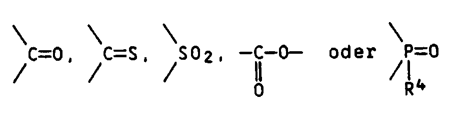
   - R¹:: ein- oder zweiwertiger organischer Rest,
   - R²:: ein- oder zweiwertiger organischer Rest,
   - R³:: ein Wasserstoffatom oder ein organischer Rest, wobei zwei Reste R³ gemeinsam einen aliphatischen, aromatischen oder heterocyclischen Ring bilden können,
   - R⁴:: ein organischer Rest, eine Hydroxylgruppe oder ein Halogenatom,
   - m:: 0, 1, 2 oder 3,
   - n:: 5-m, wenn Y und Z =CR³⁻ darstellen, und 4-m, wenn Y oder Z =N- darstellt,
   und mindestens einer der Reste R¹, R² und/oder R³ eine polymerisierbare ethylenisch ungesättigte Doppelbindung enthält,
(b) 95 bis 50 Mol% mindestens einer copolymerisierbaren olefinisch ungesättigten Silizium enthaltenden organischen Verbindung, sowie
(c) 0 bis 20 Mol% einer oder mehrerer copolymerisierbarer olefinisch ungesättigter Monomerer mit 2 bis 20 Kohlenstoffatomen
mit der Maßgabe, daß die Summe der unter (a) bis (c) genannten Prozentzahlen 100 ist und das Copolymerisat einen Siliziumgehalt von > 6 Gew.% aufweist.

Bei der Belichtung mit aktinischem Licht tritt eine Struktur- und Eigenschaftsänderung ein, durch die eine Löslichkeitsdifferenzierung zwischen belichteten und unbelichteten Bereichen hervorgerufen wird.

Bevorzugt sind erfindungsgemäße Copolymerisate die als Monomer (b) Trimethylsilylmethyl-methacrylat, 4-Trimethylsilylstyrol, 3-Methacryl-oxipropyl-tris-(trimethylsiloxi-)silan oder 4-Trimethylsilylmethyl-styrol einpolymerisiert enthalten.

Gegenstand der vorliegenden Erfindung ist außerdem ein Verfahren zur Herstellung eines Zweilagenresists, wobei als untere Lage ein im Sauerstoffplasma abbaubares Polymer und als obere Schicht ein Copolymerisat gemäß der vorliegenden Erfindung eingesetzt wird; ferner ein derartiges Verfahren zur Herstellung eines Zweilagenresists, wobei das erfindungsgemäße Polymerisat strukturiert und das Muster mit Hilfe eines Plasmas in die untere Schicht übertragen wird, wobei als Plasma vorzugsweise ein Sauerstoffplasma eingesetzt wird.

Zu den Aufbaukomponenten der erfindungsgemäßen Copolymerisate ist im einzelnen folgendes auszuführen.
(a) Bei den erfindungsgemäßen Copolymerisaten ist die Komponente (a) vorzugsweise ein Monomeres mit 1-Iminopyridinium-ylid- bzw. 1-Iminopyrazinium-ylid-gruppen, die mindestens eine aliphatisch ungesättigte, copolymerisierbare Gruppe enthalten, z.B. einen Vinyl-, Acryl- oder Methacrylrest.
   Beispiele für Monomere (a) sind: 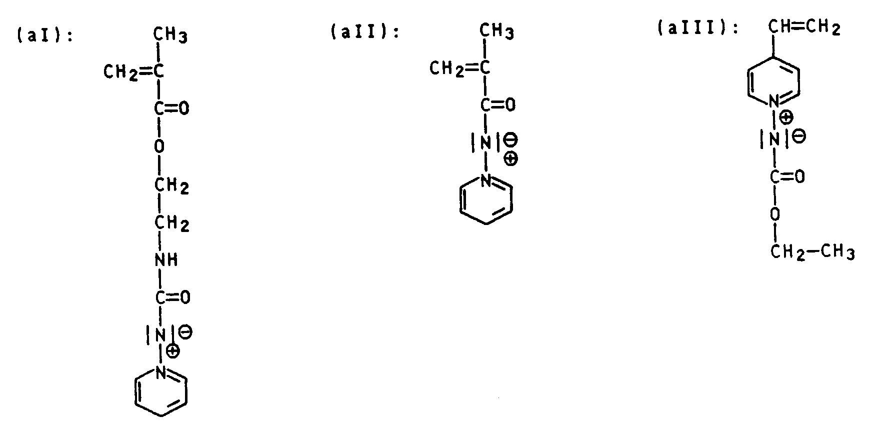 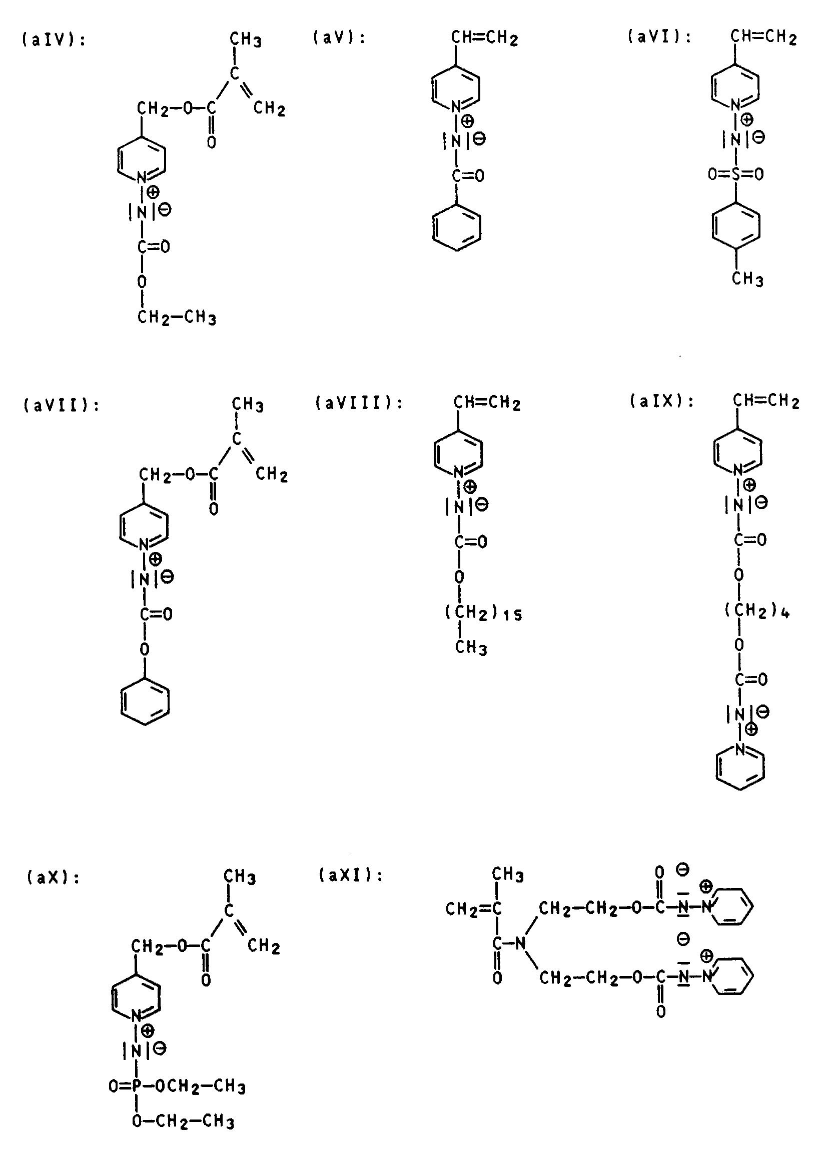 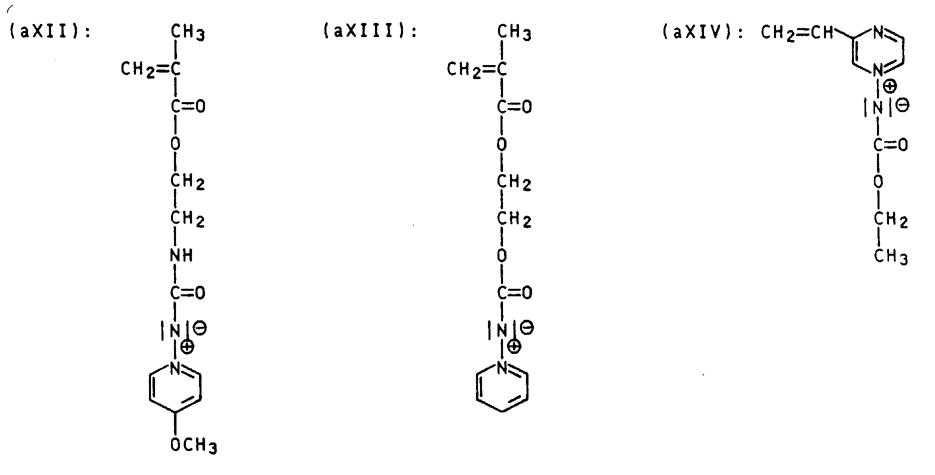 Besonders bevorzugt sind die Monomeren der Formeln (aI), (aII) und (aXIII).
   Die Synthese dieser Monomeren ist in EP-A- 0 164 100 und EP-A- 0 212 373 beschrieben.
   Die Monomeren (a) sind in den erfindungsgemäßen Copolymerisaten in Mengen von 5 bis 50 Mol% einpolymerisiert.
b) Als copolymerisierbare olefinisch ungesättigte, Silizium enthaltende Verbindungen (b), die Silizium kovalent gebunden enthalten, eignen sich beispielsweise Derivate des Styrols oder α-Methylstyrols, insbesondere 4-Trimethylsilylstyrol sowie Derivate der Acryl- oder Methacrylsäure, insbesondere Trimethylsilylmethacrylat, Trimethylsilylmethyl-methacrylat, 3-Methacryloxipropyl-bis-(trimethylsiloxi)methylsilan, 3-Methacryloxipropyl-pentamethyldisiloxan, 3-Methacryloxipropyl-tris-(trimethylsiloxi-)silan, 3-Methacryloxipropyltrimethoxisilan und 2-(Trimethylsilyl)-ethyl-methacrylat.
   Beispiele für Monomere (b) sind: 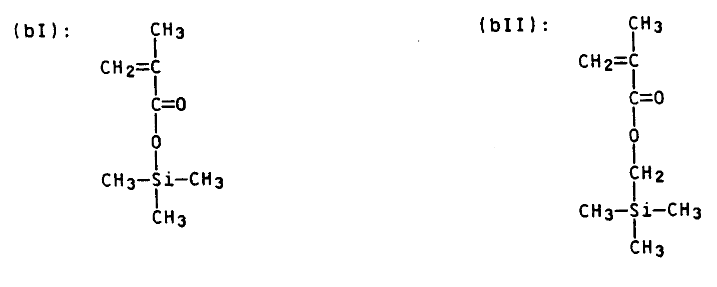 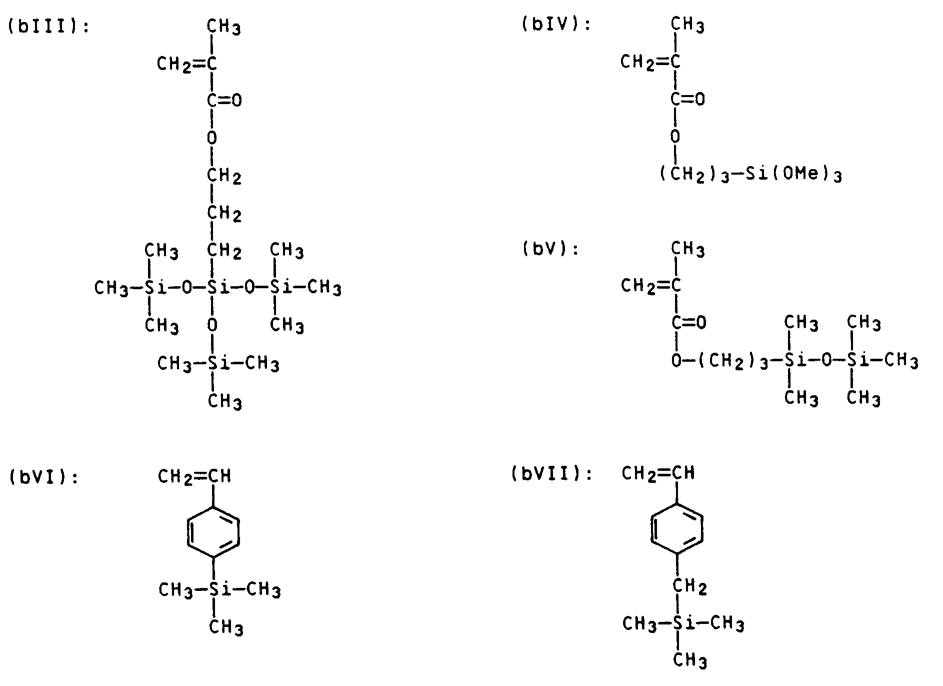 Die Monomeren (b) sind in den erfindungsgemäßen Copolymerisaten in Mengen von 95 bis 50 Mol% einpolymerisiert, wobei das Copolymerisat einen Siliziumgehalt von über 6 Gew.% aufweisen muß.
(c) Als copolymerisierbare olefinisch ungesättigte Monomere (c) können die üblichen eingesetzt werden, bevorzugt Acryl- und Methacrylsäure, sowie C₁- bis C₈-Alkylacrylate und C₁- bis C₈-Alkylmethacrylate, Acrylamide und Methacrylamide, Styrol und Styrolderivate, Acrylnitril, Vinylester, wie Vinylacetat, Vinylpyridin sowie Vinylether. Durch geeignete Auswahl der Monomeren (c) lassen sich die Eigenschaften der erfindungsgemäßen Copolymeren in weiten Grenzen variieren.
   Beispiele für Monomere (c): 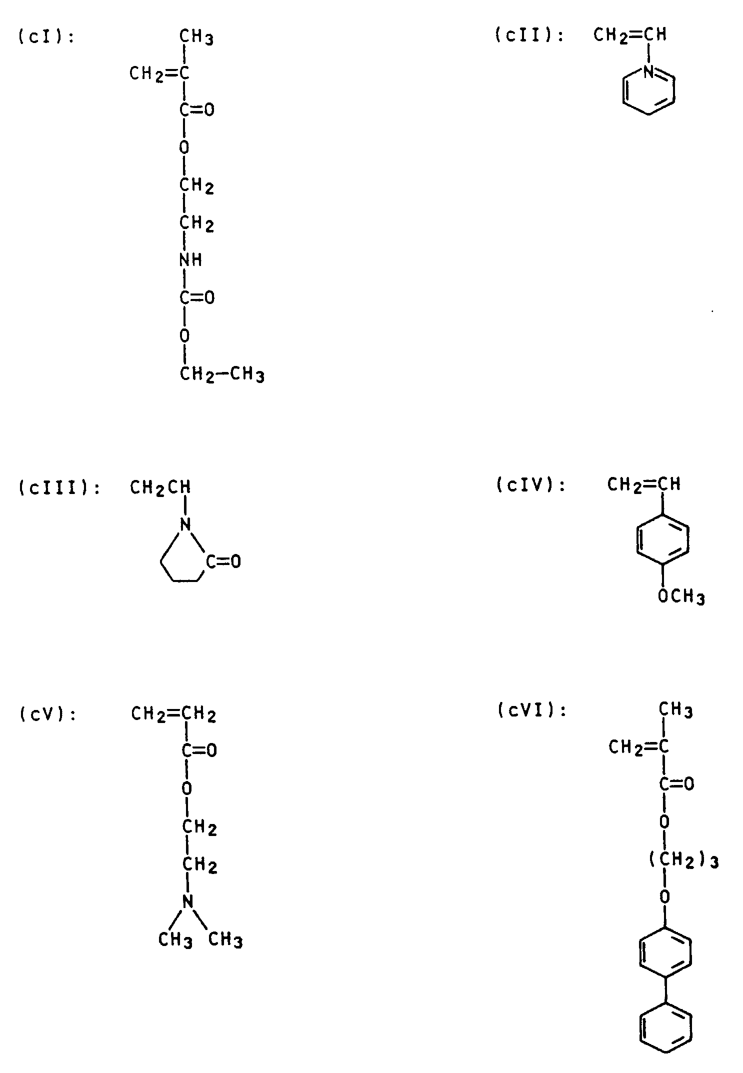 Monomere (c) können in Mengen von 0 bis 20 Mol% einpolymerisiert sein.

Die erfindungsgemäßen Copolymerisate können nach gängigen und an sich bekannten Methoden, wie z.B. der radikalischen Polymerisation aus den Monomeren (a) bis (c) hergestellt werden.

Die radikalische Polymerisation wird im allgemeinen so durchgeführt, daß man die Monomeren in einem geeigneten Lösungsmittel (z.B. Wasser, Methanol, Chloroform) löst und die von Sauerstoff befreite Lösung mit einem Polymerisationsinitiator, wie Azo-isobutyronitril, Benzoylperoxid, Azo-bis-4-cyano-pentansäure oder Kaliumperoxidisulfat, versetzt und unter Inertgasatmosphäre bei Temperaturen im Bereich zwischen 20°C und 120°C mehrere Stunden polymerisiert.

Wie bereits oben erwähnt, muß das Monomerverhältnis des Silizium enthaltenden Monomeren (b) zu photosensitiven Ylid-Monomeren (a) und weiteren Comonomeren (c) so gewählt sein, daß im resultierenden Copolymeren mindestens ein Siliziumgehalt von 6 Gew.% erhalten wird. Die Menge an Ylid-Monomeren (a) und Comonomeren (c) ist so zu wählen, daß die Polymeren in Wasser löslich sind und nach der bildmäßigen Belichtung eine Struktur- und Eigenschaftsänderung erfahren, die eine Differenzierung zwischen hydrophoben und hydrophilen Bereichen gestattet und das Monomerverhältnis zur Siliziumkomponente einen Siliziumanteil > 6 Gew.% im Polymeren ergibt.

Die erfindungsgemäßen Copolymerisate eignen sich besonders zur Herstellung von Zweilagenresisten. Die erfindungsgemäß herzustellenden Zweilagenresisten enthalten eine Planarisierungsschicht als untere Lage und eine obere Schicht aus den erfindungsgemäßen Copolymerisaten, die nach bildmäßiger Belichtung in Wasser oder leicht sauren wäßrigen Lösungen auswaschbar sind und deren so erhaltene Reliefstrukturen die Übertragung des Musters mittels Sauerstoffplasma in die Planarisierungsschicht erlauben.

Die untere Planarisierungsschicht braucht nicht lichtempfindlich zu sein und ist zweckmäßigerweise ein handelsüblicher ausgehärteter Diazochinon-Novolak-Resist, Polymethylmethacrylat oder ein Polyimid. Die Dicke der Planarisierungsschicht richtet sich nach der Höhe der Stufen auf dem Substrat, wobei üblicherweise in der Halbleiterfertigung hergestellte Substrate bei Planarisierungsschichtdicken oberhalb 1 µm eine planare Oberfläche ergeben. Eine Beschreibung der Mehrlagentechnik findet man z.B. in "Introduction to Microlithographie, ACS Symp. Ser. 219, L.F. Thompson, C.G. Willson, M.J. Bowdon, Eds., American Chemical Society, Washington DC, 1983" in Kapitel 6.

Die Dicke der oberen lichtempfindlichen Schicht hängt von der gewünschten Auflösung ab. Die Auflösung wird generell besser, je dünner die Schicht ist. Anwendbar sind Resistschichten von 0,2 bis 1 µm. Die gewünschten Schichtdicken sowohl der unteren als auch der oberen Schicht lassen sich mit Hilfe der Spin-Coating-Technik erzeugen. Das Material der unteren Schicht, beispielsweise eine Lösung eines Novolak-Resists in einem organischen Lösungsmittel wie Methylglykolacetat, kann unter Anwendung der Spin-Coating Technik aufgeschleudert werden, wobei die Schichtdicke bei konstanter Viskosität über die Drehzahl des Spinners eingestellt werden kann. Die resultierende Schicht kann dann bei Temperaturen oberhalb 160°C ausgebacken werden. Diese ausgebackene Schicht darf sich dann nicht in dem Lösungsmittel für das Polymere der oberen Schicht lösen.

Die obere Lage wird im allgemeinen ebenfalls mit Spincoating aufgebracht, wobei die Polymeren zweckmäßigerweise in Konzentrationen von 10 bis 30 Gew.% in beispielsweise Wasser oder Methylglykol bei Schleudergeschwindigkeiten von 1000 bis 10000 Umdrehungen/min in der gewünschten Schichtdicke aufgebracht werden.

Zur Strukturierung des erfindungsgemäßen Zweilagenresists wird das obere photoempfindliche Polymere mit UV-Licht im Wellenlängenbereich zwischen 400 und 300 nm bildmäßig belichtet. Die Belichtungsdosis wird so gewählt, daß kein Abtrag der belichteten Bereiche im Entwickler, bevorzugt Wasser, während der Entwicklungszeit, bevorzugt 30 bis 300 Sekunden, stattfindet. Die nichtbelichteten Bereiche lassen sich dann mit Wasser selektiv entfernen und es entstehen Reliefstrukturen.

Die so erzeugten Reliefstrukturen dienen nun als Maske für die Übertragung des Musters in die Planarisierungsschicht mit Hilfe eines Sauerstoffplasmas.

Die Sauerstoffplasmabehandlung wird bevorzugt in einem Parallelplattenreaktor durchgeführt, wobei im allgemeinen folgende Bedingungen angewandt werden: Gasdruck 20 mTorr bis 150 mTorr und Hochfrequenzgeneratorleistung zwischen 50 W und 300 W. Unter diesen Bedingungen resultieren Ätzraten für die Planarisierungsschichten von 500 Å/min bis 3000 Å/min, während sich die erfindungsgemäßen photoempfindlichen Schichten nur im Bereich zwischen 20 Å/min und 200 Å/min abtragen.

Nachdem das Maskenmuster in die Planarisierungsschicht übertragen worden ist, können die weiteren Verfahrensschritte zur Herstellung von Halbleiterbauelementen, wie Ätzen, Metallisierung, Dotierung, angewandt werden. Der Resist wird dann gestrippt und die Herstellung des Bauelementes zu Ende geführt.

Die erfindungsgemäßen Copolymerisate sind besonders vorteilhaft für die Belichtung im Mid-UV-Bereich (300 nm bis 400 nm) geeignet, da die photoaktiven Ylide ausbleichbare Absorptionsmaxima in diesem Wellenlängenbereich haben. Sie sind nach Belichtung wäßrig auswaschbar und ergeben negative Resistmuster, die im Sauerstoffplasma relativ stabil sind. Daher lassen sich die erzeugten Muster maskengetreu mit Sauerstoffplasmen übertragen. Die erfindungsgemäßen Copolymerisate sind daher ideal als lichtempfindliche Materialien für Zweilagenresiste im Mid-UV-Bereich geeignet.

Die in den Beispielen genannten Teile und Prozente beziehen sich, soweit nicht anders angegeben, auf das Gewicht.

### Beispiele

### Beispiel 1

17,2 Teile Trimethylsilylmethyl-methacrylat, 24,9 Teile des Monomeren (aI) und 1,0 Teile Azo-isobutyronitril werden in 150 Teilen einer 1:1 Mischung aus t-Butanol und Methanol gelöst. Nachdem der Sauerstoff aus der Mischung entfernt wurde, wird 16 Stunden bei 65°C polymerisiert.

Das Copolymere wird in Diethylether gefällt und im Vakuum getrocknet. Das Polymere ist löslich in Wasser, Methanol und Chloroform. Die Elementaranalyse ergibt einen Siliziumgehalt von 6,7 %.

### Beispiel 2 bis 5

In analoger Weise wie in Beispiel 1 wurden die nachfolgenden Copolymeren hergestellt. Die Polymeren wurden durch Elementaranalyse, IR-, NMR-Spektroskopie und GPC (Gelpermeationschromatographie) charakterisiert.

| Beispiel | Monomer (a) (Teile) | | Monomer (b) (Teile) | | Si-Gehalt |
|---|---|---|---|---|---|
| 2 | (aI) | (0,5) | (bIII) | (0,85) | 13,8 |
| 3 | (aII) | (1,0) | (bIII) | (2,6) | 13,6 |
| 4 | (aII) | (1,0) | (bIII) | (5,2) | 18,3 |
| 5 | (aII) | (1,0) | (bIII) | (1,3) | 8,7 |

### Beispiel 6

1,0 Teile des Monomeren (aII), 1,3 Teile des Monomeren (bII) und 0,56 Teile des Monomeren (cI) werden analog Beispiel 1 polymerisiert. Es resultiert ein wasserlösliches Polymer mit einem Siliziumgehalt von 6,5 %.

### Beispiel 7

Eine Lösung von 1,0 Teilen des in Beispiel 6 hergestellten Polymeren in 9,0 Teilen Methylglykol wird durch ein Filter mit der Porenweite 0,2 µm filtriert. Dann wird ein Teil der Lösung bei ca. 2500 Umdrehungen/min auf einen Siliziumwafer aufgescheudert. Es resultiert eine Schichtdicke von ca. 0,4 µm. Danach wird durch eine strukturierte chrombeschichtete Quarzmaske im Kontaktverfahren mit einer Quecksilberhochdrucklampe belichtet. Die Lichtintensität bei 365 nm beträgt ca. 12 mW/cm². Die Belichtung wird etwa 90 Sekunden fortgesetzt. Durch Entwickeln mit Wasser während 40 Sekunden erhält man gute Resiststrukturen.

### Beispiel 8

Die Ätzraten der erfindungsgemäßen Copolymeren und typischen Polymeren für die Planarisierungsschichten wurden in einem Parallelplattenreaktor der Fa. Plasma-Technology ermittelt. Es wurden jeweils ca. 1 µm dicke Filme der Polymeren auf Siliziumwafern hergestellt und die Wafer gleichzeitig auf der unteren Elektrode des Plasmareaktors plaziert.

Polyimid wird 30 Minuten bei 200°C, ein handelsüblicher Novolak-Resist 15 Minuten bei 140°C und 15 Minuten bei 200°C, handelsübliches Polymethylmethacrylat 30 Minuten bei 160°C und die erfindungsgemäßen Copolymeren 5 Minuten bei 80°C ausgeheizt. Ausgangsschichtdicke und Dicke nach der Ätzung werden mit einem α-step Profilometer gemessen.

| Ätzrate von Polymeren im Sauerstoffplasma | | |
|---|---|---|
| Polymer | Si-Gehalt [%] | Ätzrate [Å/min] |
| Polymethylmethacrylat | 0 | 1920 |
| Novolak-Positiv-Resist | 0 | 1060 |
| Polyamid | 0 | 610 |
| Beispiel 6 | 6,5 | 78 |
| Beispiel 5 | 8,7 | 56 |
| Beispiel 2 | 13,8 | 43 |

### Beispiel 9

Ein Siliziumwafer mit einer Oxidschicht wird mit einer 2 µm dicken Schicht eines kommerziell erhältlichen Positivresists auf Novolak-Basis überzogen und 15 Minuten bei 140°C sowie 15 Minuten bei 200°C ausgeheizt. Eine Lösung des in Beispiel 6 hergestellten Polymeren wird mit 2500 U/Minuten auf das mit dem Novolak-Resist beschichtete Substrat aufgebracht. Dann wird 5 Minuten bei 80°C ausgeheizt und durch eine mit Chromstrukturen beschichtete Quarzmaske belichtet. Die unbelichteten Bereiche werden mit reinem Wasser entfernt. Der Wafer wird auf die untere Elektrode eines Parallelplattenreaktors gelegt und 20 Minuten im Sauerstoffplasma (50 mTorr Sauerstoffpartialdruck) behandelt. Die Strukturen sind excellent übertragen und die untere Planarisierungsschicht ist an den unbelichteten Stellen komplett abgetragen.

## Patentansprüche

1. Photoreaktive, Ylid-Gruppierungen enthaltende Copolymerisate, die unter dem Einfluß von aktinischem Licht photochemische Struktur- und Eigenschaftsänderungen eingehen, dadurch gekennzeichnet, daß die Copolymerisate einpolymerisiert enthalten
(a) 5 bis 50 Mol% mindestens einer Verbindung der allgemeinen Formel (I) 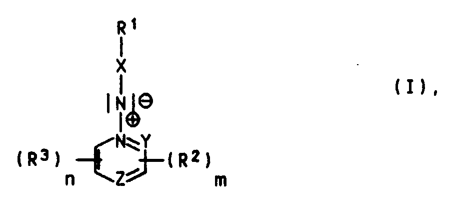 worin bedeuten:
Y und Z: =CR³- oder
Z: =N- und Y: =CR³- oder
Y: =N- und Z: =CR³-,
X: 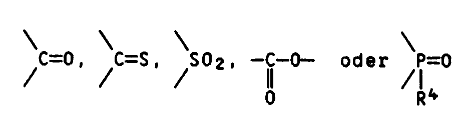
R¹: ein- oder zweiwertiger organischer Rest,
R²: ein- oder zweiwertiger organischer Rest,
R³: ein Wasserstoffatom oder ein organischer Rest, wobei zwei Reste R³ gemeinsam einen aliphatischen, aromatischen oder heterocyclischen Ring bilden können,
R⁴: ein organischer Rest, eine Hydroxylgruppe oder ein Halogenatom,
m: 0, 1, 2 oder 3,
n: 5-m, wenn Y und Z =CR³- darstellen, und 4-m, wenn Y oder Z =N- darstellt,
und mindestens einer der Reste R¹, R² und/oder R³ eine polymerisierbare ethylenisch ungesättigte Doppelbindung enthält,
(b) 95 bis 50 Mol% mindestens einer copolymerisierbaren olefinisch ungesättigten Silizium enthaltenden organischen Verbindung, sowie
(c) 0 bis 20 Mol% einer oder mehrerer copolymerisierbarer olefinisch ungesättigter Monomerer mit 2 bis 20 Kohlenstoffatomen
mit der Maßgabe, daß die Summe der unter (a) bis (c) genannten Prozentzahlen 100 ist und das Copolymerisat einen Siliziumgehalt von > 6 Gew.% aufweist.

2. Copolymerisate nach Anspruch 1, dadurch gekennzeichnet, daß sie als Monomer (a) eine Verbindung der Formel 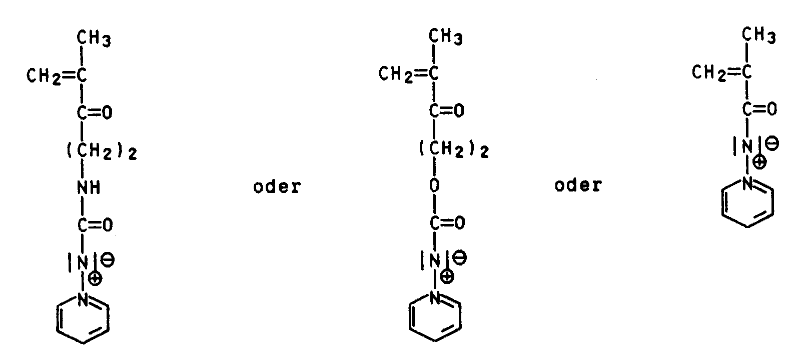 einpolymerisiert enthalten.

3. Copolymerisat nach einem der vorhergehenden Ansprüche, dadurch gekennzeichnet, daß sie als Monomer (b) Trimethylsilylmethyl-methacrylat, 4-Trimethylsilylstyrol, 3-Methacryl-oxipropyl-tris-(trimethylsiloxi-)silan oder 4-Trimethylsilylmethyl-styrol einpolymerisiert enthalten.

4. Verfahren zur Herstellung eines Zweilagenresists, dadurch gekennzeichnet, daß als untere Lage ein im Sauerstoffplasma abbaubares Polymer und als obere Schicht ein Copolymerisat gemäß einem der Ansprüche 1 bis 3 eingesetzt wird.

5. Verfahren zur Herstellung eines Zweilagenresits nach Anspruch 4, dadurch gekennzeichnet, daß das Copolymerisat gemäß einem der Ansprüche 1 bis 3 strukturiert und das Muster mit Hilfe eines Plasmas in die untere Schicht übertragen wird.

6. Verfahren nach Anspruch 5, dadurch gekennzeichnet, daß als Plasma ein Sauerstoffplasma eingesetzt wird.

## Claims

1. A photoreactive, ylide-containing copolymer which undergoes photochemical structural and property changes when exposed to actinic light, wherein the copolymer contains, as copolymerized units,
(a) from 5 to 50 mol % of one or more compounds of the general formula (I) 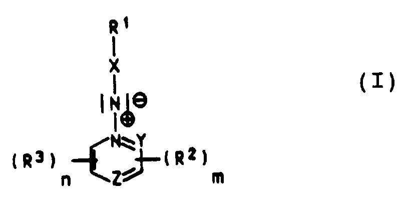 where Y and Z are each =CR³- or Z is =N- and Y is =CR³- or Y is =N- and Z is =CR³-, 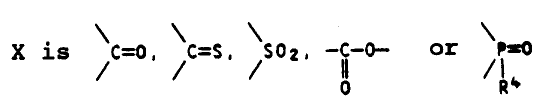 R¹ and R² are each a monovalent or divalent organic radical, R³ is hydrogen or an organic radical, and two radicals R³ may together form an aliphatic, aromatic or heterocyclic ring, R⁴ is an organic radical, hydroxyl or halogen, m is 0, 1, 2 or 3 and n is 5-m if Y and Z are each =CR³-, and 4-m if Y or Z is =N-,
and one or more of the radicals R¹, R² and/or R³ contain a polymerizable ethylenically unsaturated double bond,
(b) from 95 to 50 mol % of one or more copolymerizable olefinically unsaturated silicon-containing organic compounds
and
(c) from 0 to 20 mol % of one or more copolymerizable olefinically unsaturated monomers of 2 to 20 carbon atoms,
with the proviso that the sum of the percentages stated under (a) to (c) is 100 and the copolymer has a silicon content of > 6% by weight.

2. A copolymer as claimed in claim 1, which contains a compound of the formula 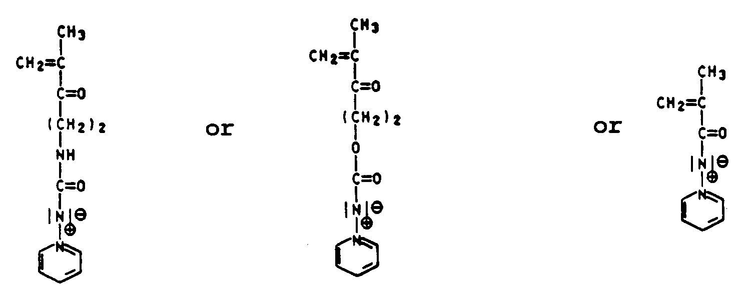 as copolymerized monomer (a).

3. A copolymer as claimed in either of the preceding claims, which contains trimethylsilylmethyl methacrylate, 4-trimethylsilyl-styrene, 3-methacryloxypropyltris-(trimethylsiloxy)-silane or 4-trimethylsilylmethyl-styrene as copolymerized monomer (b).

4. A process for the production of a two-layer resist, wherein a polymer which is degradable in an oxygen plasma is used as the lower layer and a copolymer as claimed in any of claims 1 to 3 is used as the upper layer.

5. A process for the production of a two-layer resist as claimed in claim 4, wherein the copolymer as claimed in any of claims 1 to 3 is structured and the pattern is transferred to the lower layer with the aid of a plasma.

6. A process as claimed in claim 5, wherein the plasma used is an oxygen plasma.

## Revendications

1. Copolymères photo réactifs comprenant des groupes ylide, qui subissent sous l'effet de la lumière actinique des modifications photochimiques de structure et des modifications photochimiques de leurs propriétés, caractérisés en ce que ces copolymères à l'état polymérisé contiennent
a) au moins 5 à 50 % molaires d'un composé de formule générale (I) 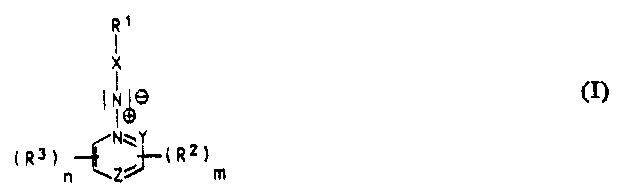 dans laquelle :
Y et Z : =CR³- ou
Z : =N- et Y : =CR³- ou
Y : =N- et Z : =CR³-,
X : 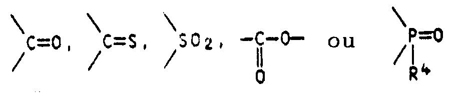
R¹ : reste organique mono ou bivalent,
R² : reste organique mono ou bivalent,
R³ : un atome d'hydrogène ou un reste organique, deux restes R³ pouvant former ensemble un cycle aliphatique, aromatique ou un hétérocycle,
R⁴ : un reste organique, un groupe hydroxyle ou un halogène,
m : 0, 1, 2 ou 3,
n : 5-m, si Y et Z représentent =CR³-, et 4-m, si Y ou Z représente =N-,
et un au minimum des restes R¹, R², et/ou R³ contient une double liaison éthylénique insaturée polymérisable,
b) au moins 95 à 50 % molaires d'un composé organique oléfinique insaturé copolymérisable contenant du silicium,
ainsi que
c) au moins 0 à 20 % molaires de un ou de plusieurs monomères oléfiniques insaturés copolymérisables comprenant de 2 à 20 atomes de carbone,
sous réserve que la somme des pourcentages cités en (a) et (b) fait 100 et que le copolymère présente une teneur en silicium supérieure à 6 % en poids.

2. Copolymères selon la revendication 1 caractérisés en ce qu'ils contiennent en tant que monomère (a) un composé de formule 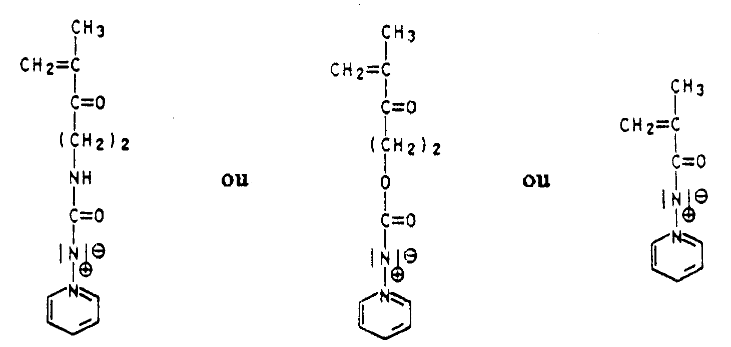 à l'état polymérisé.

3. Copolymères selon une des revendications précédentes, caractérisés en ce qu'ils contiennent, en tant que monomère (b) à l'état polymérisé, du méthacrylate de tri-méthyl-silyl-méthyle, du 4-tri-méthyl-silyl-styrol, du 3-méthacryl-oxipropyl-tris-(tri-méthyl-siloxy-)silane, ou du 4-tri-méthyl-silyl-méthyl-styrol.

4. Procédé pour la fabrication d'une réserve à deux couches, caractérisé en ce que l'on emploie comme couche inférieure un polymère pouvant être décomposé par un plasma d'oxygène et que l'on emploie comme couche supérieure, un copolymère selon une des revendications 1 à 3.

5. Procédé pour la fabrication d'une réserve à deux couches selon la revendication 4, caractérisé en ce que le copolymère est structuré selon une des revendications de 1 à 3 et que le motif est transféré dans la couche inférieure à l'aide d'un plasma.

6. Procédé selon la revendication 5, caractérisé en ce que le plasma que l'on met en oeuvre est un plasma d'oxygène.
